# EUROPEAN PATENT SPECIFICATION

(11) **EP 3 499 308 B1**
(45) Date of publication and mention of the grant of the patent: **08.07.2020**
(21) Application number: 18179880.2
(22) Date of filing: 26.06.2018
(51) Int. Cl.: G03B 21/00, G03B 21/16, G06F 1/00

(54) **METHOD FOR STARTING HEAT DISSIPATION FAN**
VERFAHREN ZUM STARTEN EINES WÄRMEABLEITUNGSLÜFTERS
PROCÉDÉ DE DÉMARRAGE DE VENTILATEUR DE DISSIPATION DE CHALEUR

(30) Priority: 18.12.2017 CN 201711366725; 18.12.2017 CN 201711368266; 18.12.2017 CN 201711364755
(43) Date of publication of application: 19.06.2019
(73) Proprietor: Qingdao Hisense Laser Display Co., Ltd., 266555 Qingdao Shandong (CN)
(72) Inventor: LIU, Jie, Qingdao, Shandong 266555 (CN)
(74) Representative: Elzaburu S.L.P.

(56) References cited:
- JP-A- 2006 301 279
- TW-A- 201 626 144
- US-A1- 2013 128 458

## Description

### TECHNICAL FIELD

The present disclosure relates to the field of electronic technologies and, in particular, to a method for starting a heat dissipation fan.

### BACKGROUND

A laser projection device has display characteristics such as large projection size, wide color gamut for pictures, high brightness, and strong interactivity, such that the laser projection device has wide adaptability in different environments, including home entertainment, business, education, and community service, bringing a new viewing experience for consumers.

The laser projection device uses a laser as a light source, its photoelectric conversion about a fraction of inch, but needs to receive an irradiation from the high-energy laser spot, moreover, thousands of micro reflectors disposed on a surface of the chip flip according to a frequency of the light source, modulate the light beam according to the image signal and reflect the light beam, a large amount of heat is also generated during reception of the irradiation and frequent flips. Therefore, the DMD chip also needs timely heat dissipation. It can be seen that, for the laser projection device, heat dissipation is a basis to ensure a normal operation of the device.

TW 201 626 144 A is describing the operation of a cooling fan with respect to decreasing the noise from the fan; US 2013/128458 A1 is dealing with the optimum cooling (and hence speed of the fan) of a projector for a given power state of the light source and JP 2006 301279 A is dealing with decreasing the cooling for the heating up period of a thermal component of a printing device.

### SUMMARY

The present disclosure provides a method for starting a heat dissipation fan, which can improve operating reliability of the fan.

To achieve the foregoing technical purpose, some embodiments of the present disclosure provide a method for starting a heat dissipation fan, the method includes:
driving a fan with a first driving voltage and detecting a rotating speed of the fan; and
in response to the rotating speed of the fan being not greater than a preset rotating speed threshold, switching a driving voltage of the fan to a third driving voltage first, and then switching the driving voltage of the fan from the third driving voltage to a second driving voltage, where the second driving voltage is greater than the first driving voltage, the third driving voltage is smaller than the first driving voltage, and the preset rotating speed threshold is configured to indicate that the fan is abnormally started.

Some other embodiments of the present disclosure provide a laser projection device, and the laser projection device includes:
a fan;
a non-volatile memory for storing instructions;
a processor coupled to the non-volatile memory, where the processor is configured to execute the instructions stored in the non-volatile memory, and the processor is configured to:
   drive the fan with a first driving voltage and detect a rotating speed of the fan;
   in response to the rotating speed of the fan being not greater than a preset rotating speed threshold, switching a driving voltage of the fan to a third driving voltage first, then switch the driving voltage of the fan from the third driving voltage to a second driving voltage, where the second driving voltage is greater than the first driving voltage, the third driving voltage is smaller than the first driving voltage, and the preset rotating speed threshold is configured to indicate that the fan is abnormally started.

### BRIEF DESCRIPTION OF THE DRAWINGS

FIG. 1A is a sectional diagram of an internal local structure of a direct current fan provided in the related art;
FIG. IB is a schematic structural diagram of a laser projection device provided in the related art;
FIG. 2 is a flowchart of a method for starting a heat dissipation fan according to some embodiments of the present disclosure;
FIG. 3 is a flowchart of a method for starting a heat dissipation fan according to some other embodiments of the present disclosure;
FIG. 4 is a flowchart of a method for restarting a heat dissipation fan used in the embodiment as shown in FIG. 3 according to some embodiments of the present disclosure;
FIG. 5 is a flowchart of another method for restarting a heat dissipation fan used in the embodiment as shown in FIG. 3 according to some other embodiments of the present disclosure;
FIG. 6 is a flowchart of another method for restarting a heat dissipation fan used in the embodiment as shown in FIG. 3 according to some other embodiments of the present disclosure;
FIG. 7 is a flowchart of another method for restarting a heat dissipation fan used in the embodiment as shown in FIG. 3 according to some other embodiments of the present disclosure;
FIG. 8 is a flowchart of another method for restarting a heat dissipation fan used in the embodiment as shown in FIG. 3 according to some other embodiments of the present disclosure; and
FIG. 9 is a flowchart of yet another method for restarting a heat dissipation fan used in the embodiment as shown in FIG. 3 according to yet some other embodiments of the present disclosure.

### DETAILED DESCRIPTION

To make the objectives, technical solutions, and advantages of the present disclosure clearer, the present disclosure will be further described in detail below with reference to the accompanying drawings. Obviously, the described embodiments are merely some embodiments of the present disclosure, rather than all embodiments of the present disclosure. All other embodiments obtained by a person of ordinary skill in the art based on the embodiments of the present disclosure without creative efforts shall fall into the protection scope of the present disclosure.

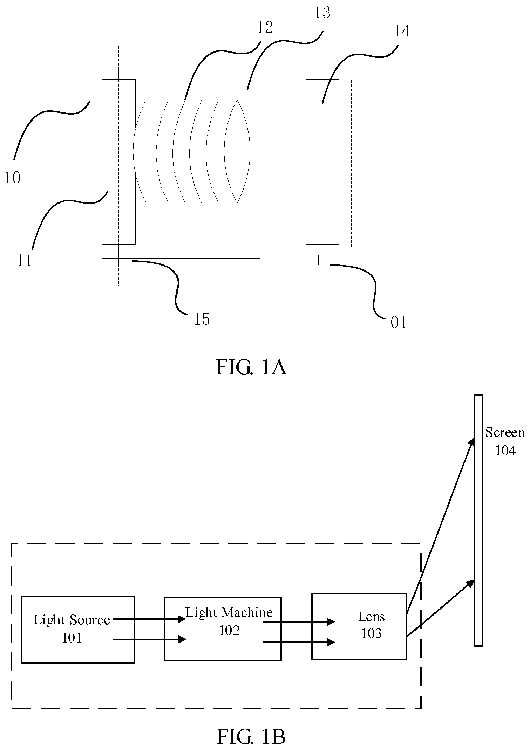

In the related art,, a main structure of a direct current fan used in the heat dissipation system is shown in FIG. 1A, in which a rotating shaft 11, a permanent magnet 14, and a blade (not shown) connected to the rotating shaft constitute a rotor 10; and a mounting seat 01, a coil 12 fixed on a housing 13 outside the rotating shaft 11, and a magnetic floating plate 15 constitute a stator. During the start-up process of the direct current fan, the coil is energized to cause a changing magnetic field therein, the coil generates a suction force or a repulsion force with the permanent magnet 14, so that the rotor 10 may begin to rotate against the inertia of the rotor 10, i.e., the blade begins to rotate. The magnetic floating plate 15, which is fixed on the mounting seat 01 and has magnetic property, can generate outward repulsive force along a center direction of the rotating shaft to push the rotor 10 outwards, so that the rotor 10 is in a floating state with respect to a bottom end of the mounting seat 01, thus there is a space between the rotor 10 and the mounting seat 01, which helps to reduce a rotating resistance of the rotor or fan. Of course, the fan may also use other known structures.

For the direct current fan in the related art, as shown in FIG. 1A, during practical applications, a rotating speed of the fan is generally proportional to a driving voltage thereof. Usually, the fan will be provided with a starting voltage when it is started. When the fan rotates normally, its driving voltage is then adjusted according to a heat dissipation requirement, so that a desired rotating speed is reached. If the fan cannot be started normally, a software program, after detecting an abnormal starting result, generally performs error reporting processing, the fan is stopped from starting, and even the electronic device is shut down to disassemble the device for a check.

FIG. 1B shows a structural schematic diagram of a laser projection device, including a light source 101, a light machine 102, a lens 103, and a projection screen 104.

A critical optical component in the light source 101 includes a laser device and a color wheel. The current laser light source is a monochromatic laser light source or a two-color laser light source. That is, the light source is composed of a laser device that emits one or two colors and fluorescent light generated from wavelength conversion. A color wheel component includes a fluorescent wheel, or a fluorescent wheel and a color filter wheel. The fluorescent wheel is excited by a laser to generate fluorescence light with a color corresponding to a wavelength conversion material, and forms three primary colors of RGB with the laser emitted from the laser device. Because the fluorescence wavelength conversion requires irradiation from a high-energy laser spot onto a surface of the fluorescent wheel, however, a continuous irradiation of a high-energy beam will cause the fluorescent wheel to locally generate a large amount of heat, or even burn-through the fluorescent wheel. Therefore, the fluorescent wheel is periodically rotated, so that the high-energy laser beam forms a circular trajectory on the fluorescent wheel, and the rotating fluorescent wheel facilitates the dissipation of heat.

The color filter wheel is disposed in a light emitting path of the fluorescent wheel with a main purpose to filter the fluorescence generated by excitation and improve the color purity, thus the color filter wheel and the fluorescent wheel rotate synchronously.

Alternatively, the laser device may be a three-color laser device, and the color wheel component may not need to be provided in the portion of the light source 101.

The light machine 102 includes a core element for DLP projection, i.e. a DMD chip composed of thousands of micro reflectors, light of three primary colors provided by the light source is received according to time sequences, an image signal is received to modulate the light of three primary colors using an imaging element according to the received image signal, and the modulated light of three primary colors that carries image content information is reflected into the lens 103 by the micro reflectors.

The DMD is very small in size, which not only requires maintaining output of light beams emitted from the light source in a time sequence, but also requires maintaining a brightness uniformity of the beams to avoid a brightness inconsistency of a screen image. Due to attenuation of the brightness of the light beams emitted from the light source over time, the brightness of the beams received in the DMD light path also change.

The lens 103, which is usually an ultra-short focus lens in a household laser projection device, serves as an imaging component to amplify and then project the light of three primary colors reflected by the DMD on the projection screen 104 for displaying, and enable the light to enter human eyes through reflection of the screen, so that a viewer can see the projected image.

The light source, the light machine and the lens portion constitute an optical engine of the laser projection device.

As mentioned above, except for the laser and the color wheel, the DMD chip is a relatively critical work component that requires timely heat dissipation, the lens and an electronic device in the laser projection device (such as a drive circuit which is not shown) cannot withstand a high temperature either. Therefore, a plurality of heat dissipation fans is generally disposed inside the laser projection device to remove heat under assistance of a heat sink. Alternatively, the laser projection device is also provided with both air-cooled and liquid-cooled heat dissipation systems inside for simultaneous heat dissipation of the laser projection device.

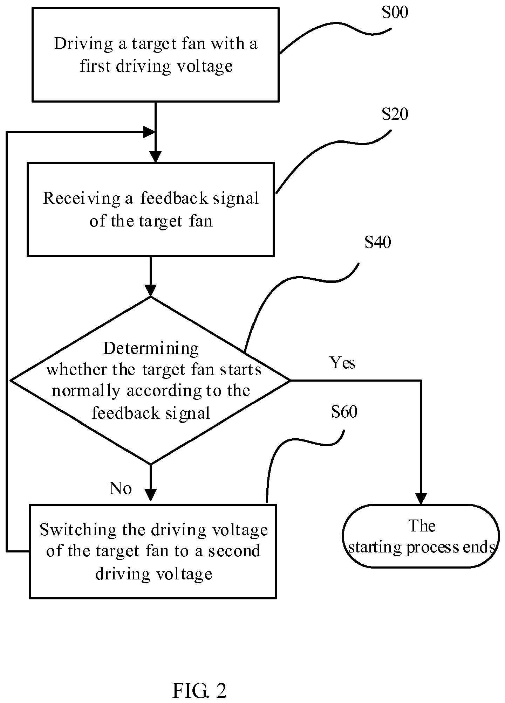

As shown in FIG. 2, some embodiments of the present disclosure provide a method for starting a heat dissipation fan, the method includes:
Step S00: driving a target fan with a first driving voltage.

The fan has a minimum operating voltage during a normal operation, that is, an operating voltage that maintains a minimum rotating speed, for example, 5V, a maximum rated operating voltage, that is, an operating voltage that maintains a maximum rotating speed, for example, 12V, and a starting voltage which may be the minimum operating voltage or is slightly higher than the minimum operating voltage, for example, 6V, used for enabling the fan to spin up. The first driving voltage is usually set as the starting voltage of the fan, so that a coil of the fan obtains a current, and a static friction force of the rotor with a magnet is overcome under a magnetic force, thus the rotor drives the fan blades to rotate.

Step S20: receiving a feedback signal of the target fan.

In some embodiments, the fan component will feedback the fan operation state to a device control chip. The feedback signal may be, for example, a rotating signal of the fan, which reflects the rotating speed at which the current fan is running, or the feedback signal may also reflect whether a time of duration for the rotating speed of the fan being zero exceeds a preset time threshold, or the feedback signal may also be a rotation flag signal of the fan reflecting whether the current fan is in a rotating state or a non-rotating state.

The fan may actively provide a feedback signal about its operation state to the device control chip at a regular time. The device control chip may also actively inquire the fan, and the fan provides the feedback signal according to the query command. Alternatively, the control chip may actively detect the rotating speed of the fan.

Step S40: determining whether the target fan is started normally according to the feedback signal.

In some embodiments, there are many methods to determine whether the target fan is started normally, for example:
It can be determined whether the rotating signal of the target fan is zero. The rotating signal of the fan may be a specific rotating value, for example, 240 rotatings or 120 rotatings per second. If it is zero, it indicates that the fan does not rotate, and then it is determined that the fan is abnormally started; if it is not zero, it indicates that the fan has a rotating speed, then it is determined that the fan is normally started. The rotating signal of the fan may be a rotating signal measured by the Hall sensor of the fan component and fed back to the device control chip.

Alternatively, when the rotating speed of the fan is zero, it can be further determined whether the time of duration for the rotating speed of the fan being zero exceeds the preset time threshold. If the time of duration for the rotating speed of the fan being zero exceeds the preset time threshold, then it is determined that the fan is abnormally started. If the time of duration for the rotating speed of the fan being zero does not exceed the preset time threshold, then it is determined that the fan is normally started.

Alternatively, an actual rotating speed fed back by the fan may be compared with a rotating speed corresponding to the driving voltage of the current fan. If there is an obvious difference, for example, a corresponding range of rotating speeds theoretically designed for the driving voltage of the fan is 500-600 rpm, but the actual rotating speed fed back by the fan is 200 rpm, this indicates that the rotation of the fan is blocked.

Alternatively, the rotation flag signal of the target fan may be determined, for example, it may be a case whether the rotation flag signal of the fan is true, the fan will feedback a flag bit value after it starts running, if the rotation flag signal of the fan is not true, it indicates that the fan is not rotated, then it is determined that the fan is abnormally started; if the rotation flag signal of the fan is true, it indicates that the fan has been rotated, then it is determined that the fan is normally started. Alternatively, the rotation flag signal of the fan may be a high level signal or low level signal, for example, a high level represents a successful spin-up, and a low level represents an unsuccessful spin-up. The rotation flag signal of the fan may be a pulse signal fed back by a sensor or a control circuit of the fan component and is fed back to the device control terminal.

Alternatively, the feedback signal of the target fan is actively detected at a regular time, and if the feedback signal of the target fan is not detected for N consecutive times, then it is determined that the fan is abnormally started; otherwise, it is determined that the fan is normally started. The feedback signal of the target fan may be the rotation flag signal of the fan or the rotating signal of the fan, or the feedback signal of the fan may also reflect whether the time of duration for the rotating speed of the fan being zero exceeds the preset time threshold.

Alternatively, within the time threshold, for example, a time range is preset to wait for reception of the feedback signal of the target fan. If the feedback signal of the fan is not received within the time threshold, then it is determined that the fan is abnormally started; otherwise, it is determined that the fan is normally started. The feedback signal of the fan may be, for example, the rotation flag signal of the fan or the rotating signal of the fan; alternatively, the feedback signal of the fan may also reflect whether the time of duration for the rotating speed of the fan being zero exceeds the preset time threshold.

Therefore, whether the fan is normally started may include: whether the fan is running according to the rotating speed corresponding to the driving voltage; whether the fan is normally rotated during a starting-up process; and whether the fan maintains a normal communication handshake with the device control chip. The foregoing situations are only examples, and the technical solutions of the present disclosure are not limited thereto. Any parameter and signal related to the working process of the fan can be considered according to actual requirements as a condition for determining whether the fan is normally started.

If it is determined that the fan is abnormally started, then proceed with a process for restarting the target fan. In some embodiments, the process for restarting the target fan includes, for example, performing Step S60: switching a driving voltage of the fan to a second driving voltage, where the second driving voltage is greater than the first driving voltage. After Step S60 is performed, the process returns to Step S20: receiving the feedback signal of the target fan.

In some embodiments of the present disclosure, after the device control terminal determines that the fan is abnormally started according to the feedback signal of the fan, then proceed with the process for restarting the target fan.

If it is determined that the fan is normally started, the starting process ends, and then no processing is performed, or a corresponding driving voltage is applied to the fan according to the heat dissipation requirement of the device system, so that the rotating speed of the fan is adjusted to a desired rotating value for the fan to work and a heat dissipation effect is achieved, or proceed with a process for determining whether the fan is normally running.

The process for determining whether the fan is normally running includes: receiving a feedback signal of the target fan, and determining whether the target fan is normally running according to the feedback signal. In some embodiments, there are many methods to determine whether the target fan is normally running. For example, reference may be made to the method for determining whether the fan is normally started in Step S40, and details will not be described herein again.

Therefore, whether the fan is normally running may include: whether the fan rotates normally with no stalling; whether the fan runs according to the rotating speed corresponding to the driving voltage; and whether the fan maintains a normal communication handshake with the device control chip. The foregoing situations are only examples, and the technical solutions of the present disclosure are not limited thereto. Any parameter and signal related to the working process of the fan can be considered according to actual requirements as a condition for determining whether the fan is normally running.

If it is determined that the fan is normally running, then no processing is performed, or a corresponding driving voltage is applied to the fan according to the heat dissipation requirement of the device system so that the rotating speed of the fun is adjusted to a desired rotating value for the fan to work and a heat dissipation effect is achieved;

If it is determined that the fan is started abnormally, the driving voltage of the fan is switched to a higher driving voltage than the current driving voltage, and then the feedback signal of the target fan is received, and it is determined whether the target fan is normally running according to the feedback signal.

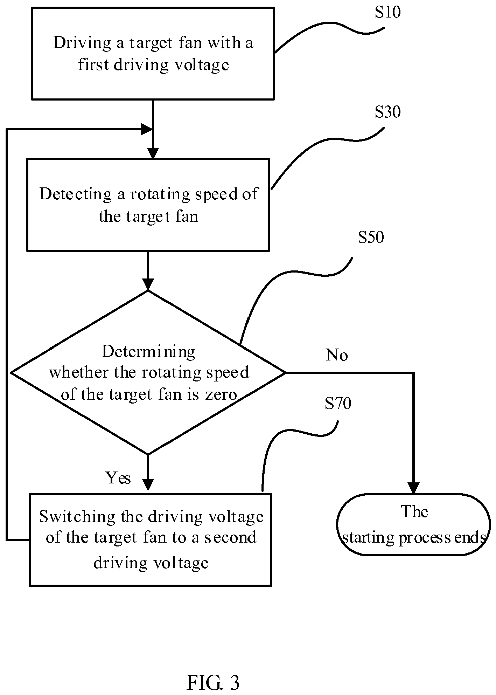

Some other embodiments of the present disclosure provide a method for starting a heat dissipation fan. As shown in FIG. 3, the method includes:
Step S10: driving a target fan with a first driving voltage;
Step S30: detecting a rotating speed of the target fan;
Step S50: determining whether the rotating speed of the target fan is zero;
If it is determined that the rotating speed of the target fan is zero, then proceed with a process for restarting the target fan. In some embodiments, the process for restarting the target fan includes, for example, performing Step S70: switching the driving voltage of the target fan to a second driving voltage.

If it is determined that the rotating speed of the target fan is not zero, the starting process ends, and then no processing is performed, or a corresponding driving voltage is applied to the fan according to the heat dissipation requirement of the device system, so that the rotating speed of the fan is adjusted to a desired rotating value for the fan to work and a heat dissipation effect is achieved, or proceed with a process for determining whether the fan is normally running.

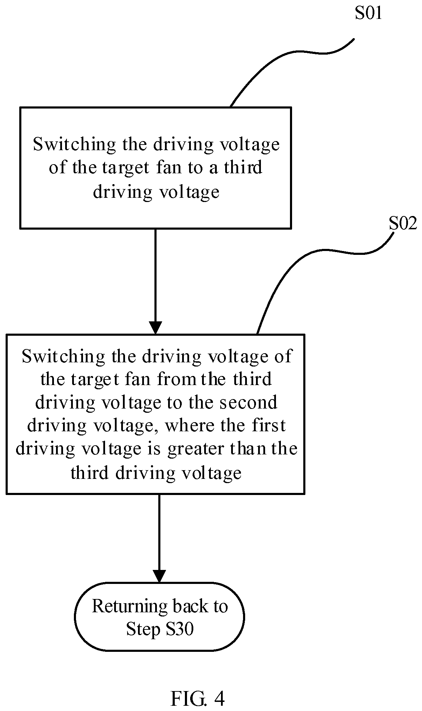

In some embodiments, as shown in FIG. 4, Step S70, the switching the driving voltage of the target fan to the second driving voltage may include:
Step S01: switching the driving voltage of the target fan to a third driving voltage;
Step S02: switching the driving voltage of the target fan from the third driving voltage to the second driving voltage, where the first driving voltage is greater than the third driving voltage.

First, the current driving voltage of the target fan, of which the rotating speed is determined to be zero, is first reduced to the third driving voltage, and then increased from the third driving voltage to the second driving voltage to drive the target fan. One case is that if it is determined that the rotating speed of the fan is zero, and the current driving voltage of the fan is a starting voltage, then the starting voltage is reduced to the third driving voltage which may be significantly lower than the starting voltage. Then, the driving voltage is increased to the second driving voltage, and the target fan is driven with the second driving voltage, where the second driving voltage is significantly higher than the third driving voltage and is also greater than the current driving voltage of the target fan. Next, the process returns to Step S30, and then Step S50 is performed to determine whether the starting is successful when the fan was driven with the second driving voltage.

In some embodiments, the second driving voltage may be in a value range, for example, smaller than or equal to the maximum rated operating voltage, but greater than or equal to 80% of the maximum rated operating voltage, or smaller than or equal to the maximum rated operating voltage, but greater than or equal to a first value, where the first value is determined according to the following equation: the first value = the first driving voltage+ 50%* (the maximum rated operating voltage - the minimum operating voltage). In some embodiments, the second driving voltage may be smaller than or equal to 1.2 times the maximum rated operating voltage, but greater than the maximum rated operating voltage, and the third driving voltage may take a value of zero. Since the driving voltage of the fan may temporarily exceed the rated voltage without damaging the fan, the second driving voltage may be greater than the rated voltage, so that the fan rotor will obtain a larger voltage difference change with an attempt to restart the fan, which may be converted into a larger spinning force, thereby improving a probability for the fan to successfully rotate. In an embodiment where the second driving voltage is smaller than or equal to 1.2 times the maximum rated operating voltage of the fan, but greater than the maximum rated operating voltage, after the driving voltage of the fan is switched to the second driving voltage and the rotation of the fan is completed, the method for starting the heat dissipation fan further includes switching the driving voltage of the fan to a case smaller than or equal to the maximum rated operating voltage of the fan. For example, after the driving voltage of the fan is switched to the second driving voltage for a preset time, the driving voltage of the fan is switched from the second driving voltage to the maximum rated operating voltage of the fan.

Alternatively, the third driving voltage takes a non-zero smaller value, such as a fraction of a volt, and the second driving voltage takes a larger voltage value, a very large driving voltage difference may also be obtained, providing a larger spinning force for the rotor of the target fan and facilitating successful rotation of the fan. Alternatively, the third driving voltage may take a value range greater than or equal to zero, but smaller than or equal to the minimum operating voltage. The minimum operating voltage refers to a driving voltage maintaining the fan to operate at a rated minimum rotating speed.

In some embodiments, the second driving voltage may be set, for example, as the maximum rated operating voltage of the target fan, and the third driving voltage may be, for example, zero volt. When the third driving voltage is zero, the fan may be driven and controlled to output a signal corresponding to zero volt voltage, and the system may also be powered off, both of which can achieve the effect that the target fan has no driving voltage. In this way, the target fan may be provided with a highest driving voltage (within a range of driving voltages that the fan carries) when it is restarted, and the rotor of the fan obtains a change in a maximum instantaneous magnetic field which interacts with the permanent magnet to generate a maximum spinning force, so that the probability for the rotor to successfully rotate is greatly increased, and thus it is easier to complete the normal startup.

In addition, when the second driving voltage is set as the maximum rated operating voltage, the third driving voltage may also take a value larger than zero but is smaller, such as a fraction of a volt, which can also achieve the purpose of enabling the rotor of the fan to obtain a large spinning force, facilitating the successful rotation.

In some embodiments of the present disclosure, the switching from the third driving voltage to the second driving voltage to drive the target fan may include, for example, switching from the third driving voltage to the second driving voltage and maintaining output for a first preset time period. In some embodiments of the present disclosure, the first preset time period does not limit the length of the time, and may be, for example, a time period in units of seconds or microseconds. By maintaining the output of the second driving voltage for a certain time period, the driving voltage can be stably outputted, and a conversion of electromagnetic energy to kinetic energy is continued for a certain time period, which also helps to overcome the frictional force and allows for a successful rotation.

In this way, after the target fan is provided with a new higher driving voltage, the process returns to Step S30, and Step S50 is performed to determine once again whether the rotating speed of the fan is zero. If the rotating speed of the fan is not zero, the present starting process ends, and no processing is performed then, or a corresponding driving voltage is applied to the fan according to the heat dissipation requirement of the device system so that the rotating speed of the fan is adjusted to a desired rotating value for the fan to work and a heat dissipation effect is achieved, or proceed with a process of determining whether the fan is normally operating. If the rotating speed of the fan is zero, Step S01 and Step S02 are sequentially performed again, then the process returns to Step S30, and Step S50 is performed to determine once again whether the fan is normally started.

In addition, the switching the driving voltage of the target fan to the third driving voltage, for example, includes: switching the driving voltage of the target fan to the third driving voltage, and maintaining output for a second preset time period, where the second preset time period is less than or equal to the first preset time period.

In some embodiments of the present disclosure, the second preset time period may be zero. That is, after the current driving voltage of the target fan is switched to the third driving voltage, it is instantaneously switched to the second driving voltage. This case can be regarded as that the length of the second preset time period is zero.

During an actual operation, considering the time taken for signal switching and for the purpose of reducing the impact of frequent switching on the circuit, the second preset time period may be set to have a certain length of time, but this length of time is much smaller than the first preset time period.

According to the method for starting the fan provided hereinabove, during the starting process of the heat dissipation fan, the rotating speed of the target fan is detected, and it is determined whether the rotating speed of the target fan is zero. If it is determined that the rotating speed of the fan is zero, the target fan is restarted. During the restarting process of the target fan, the driving voltage of the target fan is first reduced and then increased to drive the fan again, which can provide the target fan with a large voltage difference change. According to the principle of electromagnetic driving, the magnetic rotor inside the target fan may obtain a higher rotation driving force. It is easier for the rotor to overcome its inertia and for the target fan to rotate successfully and run normally. Without affecting normal operations of other components of the laser projection device, a self-recovery starting process is applied in the abnormal fan, which improves the probability for the fan to successfully restart and the continuity of the operation of the fan, and also improves the reliability of the operation of the fan. The technical solution of the present disclosure provides a self-recovery mechanism of the fan, which enables the abnormal fan to automatically restart and continue to run after successfully restarting in order for heat dissipation, the reliability of the control of the fan is improved, normal operations of other components of the device will not be affected, and maintenance costs of the device are reduced.

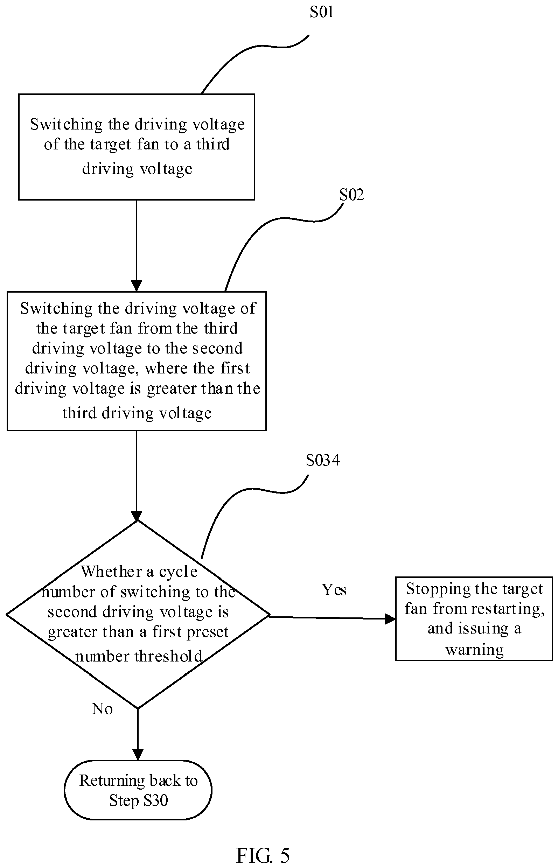

Based on the embodiment of the method for restarting the heat dissipation fan as shown in FIG. 4, in some other embodiments, as shown in FIG. 5, after Step S02 and before returning back to Step S30, the method further includes Step S034: determining whether a cycle number of switching to the second driving voltage is greater than a first preset number threshold; if it is greater than the first preset number threshold, then stopping the target fan from restarting, and issuing a warning; if it is not greater than the first preset number threshold, returning back to Step S30, where the first preset number threshold is an integer greater than or equal to 1.

In some embodiments, the first preset number threshold may be set to 1 or 2, or 3, or 5, which may be adjusted according to software design requirements. Therefore, after a limited number of attempts to restart, the action of restarting the fan is stopped if the restarting process is still unsuccessful, the fan is considered to be in abnormality and a warning is issued.

In some embodiments, the second driving voltage and the third driving voltage may be in a value range, where the second driving voltage may gradually increase with a change of the first preset number threshold, but is always smaller than the maximum rated operating voltage, and the third driving voltages may gradually decrease with the change of the first preset number threshold, therefore, as the number of restart failures increases, the driving voltage may be gradually adjusted and increased, and the voltage difference applied to the target fan may be increased to increase the probability of successfully rotating at a next time. Alternatively, the third driving voltage and the second driving voltage may also be set to the same determined value each time.

It should be noted that Step S034 may be performed at the latest before turning to Step S30: detecting a rotating speed of the target fan. As shown in FIG. 5, Step S034 may be performed, after Step S01: switching the driving voltage of the target fan to a third driving voltage and before Step S02: switching the driving voltage of the target fan from the third driving voltage to the second driving voltage; or performed after Step S02: switching the driving voltage of the target fan from the third driving voltage to the second driving voltage and before Step S30: detecting a rotating speed of the target fan; or performed synchronously with Step S01: switching the driving voltage of the target fan to a third driving voltage or Step S02: switching the driving voltage of the target fan from the third driving voltage to the second driving voltage or Step S30: detecting a rotating speed of the target fan.

In addition, for example, the issuing the warning may include: reporting a fan failure, that is, determining that the fan is in abnormality, and shutting down the critical operating components. For example, the laser device is first turned off, and then the color wheel and the DMD chip are turned off. Alternatively, the issuing the warning may include: reporting a fan failure and turning off the laser projection device or controlling the laser projection device to enter a standby mode.

In some embodiments of the present disclosure, by limiting the number of times of restarting the target fan, it is possible to prevent the target fan from falling into an infinite number of times of restarting, realize effective operation control, and promptly discover the problem of failure.

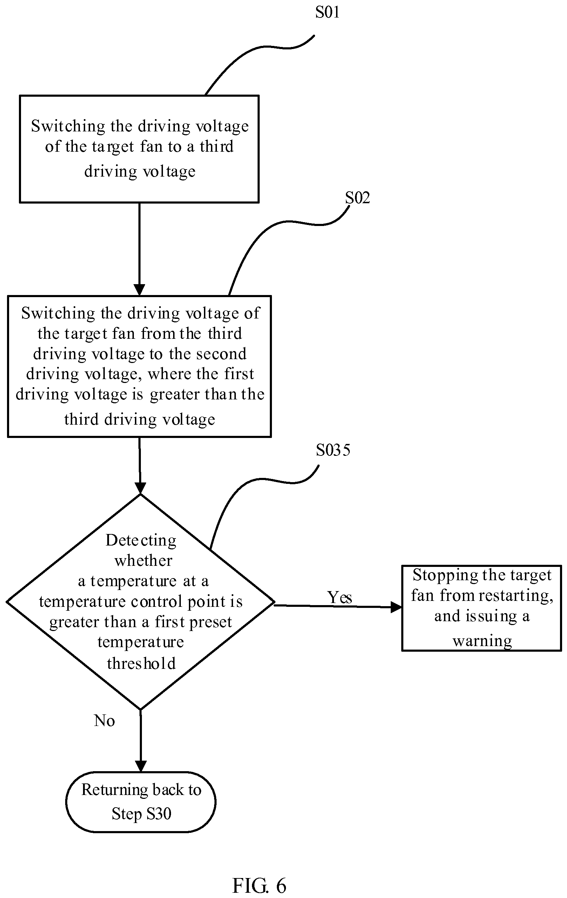

In addition, different from the technical solution of setting the cycle number as mentioned above, in some other embodiments, as shown in FIG. 6, after Step S02 and before returning back to Step S30, the method further includes Step S035:
detecting whether a temperature at a temperature control point is greater than a first preset temperature threshold,
if it is greater than the first preset temperature threshold, stopping the fan from starting, and issuing a warning;
if it is not greater than the first preset temperature threshold, returning back to Step S30.

The fan is used to dissipate heat from the laser projection device or a specific operating component in the device. If the fan cannot operate normally, the temperature inside the device may rapidly increase. Generally, one or more temperature control points are provided inside the device for detecting an environmental temperature inside the device, especially, a critical operating component inside the device is generally provided with a temperature control point, such as a laser light source component and a color wheel component inside the laser projection device, if the temperature is too high, an irreversible damage may be caused. Thus, it is very necessary to provide the temperature control point.

In some method embodiments of the present disclosure, detect whether the temperature at one or more temperature control points is greater than a first preset temperature threshold, if it is greater than the first preset temperature threshold, it indicates that the temperature inside the device rises too fast and a temperature factor needs to be considered preferentially. In this case, stop attempting to restart the target fan and issue a warning. The warning may include reporting a fan failure, that is, determining that the fan is in abnormality, and shutting down the critical operating components, or reporting a fan failure and turning off the operating power source of the device, or controlling the device to enter a standby mode.

In some product applications, such as the laser projection device, if the temperature rise in the device is high, it indicates that accumulation of a large amount of heat has been caused due to abnormal operation of the fan. If the restarting of the fan continues, there may be an adverse consequence, for instance, a component is damaged, the phosphor on the surface of the color wheel gets burned, or an optical lens is deformed on its surface, and even an optical device is punctured by a high-energy laser. Therefore, at this time, it needs to determinate that the fan is in abnormality, and a warning measure needs to be taken promptly, for example, turn off the laser, and report a fan failure, or turn off the power source of the laser projection device or control the laser projection device to enter a standby mode, and report a fan failure.

Similar to the embodiment as shown in FIG. 5, in some method embodiments of the present disclosure, Step S035 may be performed at the latest before turning to Step S30: detecting a rotating speed of the target fan. As shown in FIG. 6, Step S035 may be performed after Step S01: switching the driving voltage of the target fan to a third driving voltage and before Step S02: switching the driving voltage of the target fan from the third driving voltage to the second driving voltage; or performed after Step S02: switching the driving voltage of the target fan from the third driving voltage to the second driving voltage and before Step S30: detecting a rotating speed of the target fan; or performed synchronously with Step S01: switching the driving voltage of the target fan to a third driving voltage or Step S02: switching the driving voltage of the target fan from the third driving voltage to the second driving voltage or Step S30: detecting a rotating speed of the target fan.

In some method embodiments of the present disclosure, by considering the temperature at the temperature control point in the operating environment where the fan is located, the temperature change of the temperature control point is used as a condition to determine the restarting of the fan, so that the self-recovery restarting process of the fan is performed when no serious heat accumulation is caused to the device, which is closer to actual application requirements of the product. Also, the temperature change of the temperature control point herein may include the temperature of the critical operating component or the environmental temperature around the position where the target fan is located.

Alternatively, in some other embodiments, both the determination of whether the cycle number exceeds the preset number threshold and the determination of whether the temperature at the temperature control point is greater than the preset temperature threshold may be made, but these two determination conditions have a priority, i.e., a sequential order for the determinations, for example, for the laser projection device, the focus may be the temperature rise factor. Therefore, it may be determined first whether the temperature at the temperature control point is greater than the preset temperature threshold, if not, it is then determined whether the cycle number exceeds the preset number threshold.

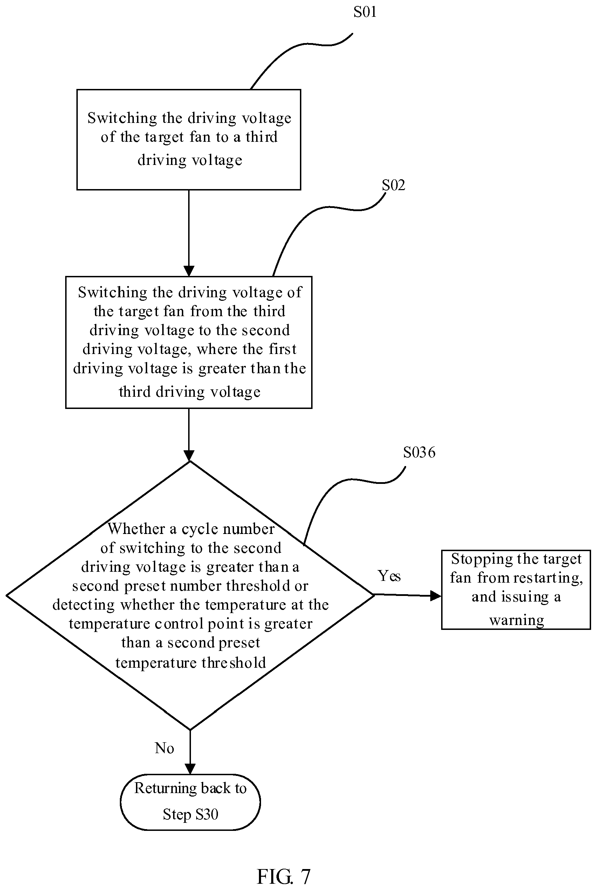

Alternatively, in some other embodiments, after Step S02 and before returning back to Step S30, as shown in FIG. 7, the method further includes Step S036:
determining whether a cycle number of switching to the second driving voltage is greater than a second preset number threshold or detecting whether a temperature at a temperature control point is greater than a second preset temperature threshold,
if the cycle number is greater than the second preset number threshold or the temperature at the temperature control point is greater than the second preset temperature threshold, stopping the fan from restarting, and issuing a warning;
if the cycle number is not greater than the second preset number threshold and the temperature at the temperature control point is not greater than the second preset temperature threshold, returning back to Step S30; where the second preset number threshold is an integer greater than or equal to 1.

In this embodiment, both the cycle number of switching to the second driving voltage and the temperature at the temperature control point are monitored. If any one of the cycle number and the temperature at the temperature control point reaches the set condition or both of them reach the set condition simultaneously, that is, if the cycle number is greater than the second preset number threshold or the temperature at the temperature control point is greater than the second preset temperature threshold or both of them are satisfied, the target fan is stopped from restarting and a warning is issued. Only when both set conditions are not reached for the two determinations, would the process return back to Step S30.

Similar to the embodiments as shown in FIG. 5 and FIG. 6, in some method embodiments of the present disclosure, Step S036 may be performed at the latest before turning to Step S30: detecting a rotating speed of the target fan. As shown in FIG. 7, Step S036 may be performed after Step S01: switching the driving voltage of the target fan to a third driving voltage and before Step S02: switching the driving voltage of the target fan from the third driving voltage to the second driving voltage; or performed after Step S02: switching the driving voltage of the target fan from the third driving voltage to the second driving voltage and before Step S30: detecting a rotating speed of the target fan; or performed synchronously with Step S01: switching the driving voltage of the target fan to a third driving voltage or Step S02: switching the driving voltage of the target fan from the third driving voltage to the second driving voltage or Step S30: detecting a rotating speed of the target fan.

By determining the above two limited conditions, both factors such as the temperature and the length of starting time are taken into considerations, so that the fan restarting process is performed in a limited number of attempts without causing serious heat accumulation to the device, which brings more practical operability and may improve the operation reliability of the device.

According to one or more technical solutions provided in some embodiments of the present disclosure, a rotating speed of the target fan can be detected during the starting process of the heat dissipation fan, if it is determined that the rotating speed of the target fan is zero, then the target fan is restarted, and the abnormal fan can be performed with a self-recovery starting processing without affecting the normal operation of other components of the laser projection device, which improves the continuity of the operation of the fan and also improves the reliability of the operation of the fan. The technical solution of the present disclosure provides a self-recovery mechanism of the fan, which enables the abnormal fan to automatically restart and continue to run after successfully restarting perform order for heat dissipation, normal operations of other components of the device will not be affected, and maintenance costs of the device are reduced.

During the restarting process of the fan, the driving voltage of the target fan is first reduced and then increased, which provides the rotor of the fan with a large voltage difference, provides a relatively large rotation driving force and can improve the probability for the fan to successfully rotate.

In addition, by setting the cycle number or monitoring the temperature control point during the restarting process of the fan, the restarting process of the target fan after the abnormality determination is performed in a limited number of attempts without causing serious heat accumulation in the device, reducing the adverse impact on the device, bringing more practical operability, and satisfying the actual operation requirements of the product.

Some other embodiments of the present disclosure provide a method for starting a heat dissipation fan. Different from the embodiments of FIG. 3-FIG. 7, after it is determined that the fan is abnormally started, the method, when switching the driving voltage of the target fan to the second driving voltage, simultaneously switches a driving voltage of at least one surrounding fan disposed around the target fan. For example, the driving voltage of the at least one surrounding fan may be increased so that there is an increased wind pressing force in the rotating direction of the target fan.

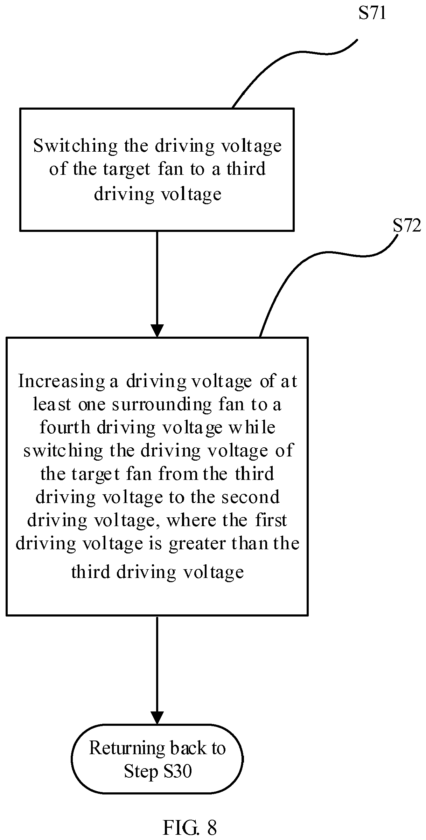

The improved solution may be an improvement based on the flow method as shown in FIG. 4. The starting method is, for example, shown in FIG. 8:
Step S71: switching the driving voltage of the target fan to a third driving voltage.

In some embodiments of the present disclosure, the third driving voltage may be significantly lower than the first driving voltage.

Step S72: increasing a driving voltage of at least one surrounding fan to a fourth driving voltage while switching the driving voltage of the target fan from the third driving voltage to the second driving voltage, where the first driving voltage is greater than the third driving voltage, and the fourth driving voltage is greater than the driving voltage of the at least one surrounding fan before the switching.

After Step S72: increasing a driving voltage of at least one surrounding fan to a fourth driving voltage while switching the driving voltage of the target fan from the third driving voltage to the second driving voltage is performed, the process returns back to Step S30, and then proceed with Step S50: determining whether the rotating speed of the target fan is zero.

If it is determined that the rotating speed of the target fan is not zero, the starting process ends, and then no processing is performed, or a corresponding driving voltage is applied to the fan according to the heat dissipation requirement of the device system, so that the rotating speed of the fan is adjusted to a desired rotating value for the fan to work and a heat dissipation effect is achieved, or proceed with a process for determining whether the fan is normally operating.

If it is determined that the rotating speed of the target fan is zero, Step S71 and Step S72 are sequentially performed again, and then the process returns back to Step S30, and Step S50 is performed to determine once again whether the fan is normally started.

During the restarting process of the target fan, the driving voltage of the target fan is first reduced and then increased to drive the fan again. Such change in the driving voltage can provide the target fan with a large voltage difference change. According to the principle of electromagnetic driving, the magnetic rotor inside the target fan may obtain a higher rotation driving force. At the same time, increasing the driving voltage of the at least one surrounding fan disposed around the target fan can drive the airflow around the target fan to rapidly flow, thereby generating an auxiliary driving force for the target fan. With cooperation of the auxiliary driving force and the target fan's own driving force, it is easier to overcome the inertia of the rotor and increase the probability for the fan to successfully run. The larger the difference between the second driving voltage and the third driving voltage, the greater the change in the spinning force given to the fan to run again; and the higher the fourth driving voltage, the greater the auxiliary airflow driving force given to the target fan, therefore, the higher the probability for the fan to successfully restart.

In some embodiments, the second driving voltage and the fourth driving voltage may be the maximum rated operating voltage of the target fan or in a value range close to the maximum rated operating voltage, for example, smaller than or equal to the maximum rated operating voltage, but greater than or equal to 80%* the maximum rated operating voltage, smaller than or equal to the maximum rated operating voltage, but greater than or equal to the first value, where the first value is determined according to the following equation: the first value = the first driving voltage+50%*(the maximum rated operating voltage- the minimum operating voltage), or smaller than or equal to 1.2 times the maximum rated operating voltage of the fan, but greater than the maximum rated voltage. In an embodiment where the second driving voltage and the fourth driving voltage are smaller than or equal to 1.2 times the maximum rated operating voltage of the fan, but greater than the maximum rated voltage, after the driving voltage of the fan is switched to the second driving voltage and/or the driving voltage of the at least one surrounding fan is increased to the fourth driving voltage, the method for starting the heat dissipation fan further includes switching the driving voltage of the fan from the second driving voltage to the maximum rated operating voltage of the fan and/or switching the driving voltage of the at least one surrounding fan to the maximum rated operating voltage of the fan. For example, after the driving voltage of the fan is switched to the second driving voltage for a preset time, the driving voltage of the fan is switched from the second driving voltage to the maximum rated operating voltage of the fan; and after the driving voltage of the at least one surrounding fan is increased to the fourth driving voltage for a preset time, the driving voltage of the at least one surrounding fan is switched from the fourth driving voltage to the maximum rated operating voltage of the fan. The surrounding fans refer to other fans at the proximity of the fan.

In an actual heat dissipation system of an electronic device, more than one fan is generally disposed, and an air inlet and an air outlet are disposed to form an air duct. The cool air enters from the air inlet, which carries heat to change into the hot air and is discharged from the air outlet. The fans will also be arranged in a rough direction along the airflow direction of the air duct. When the target fan is not normally started for the first time, in addition to increasing the driving voltage of the fan, a wind pressure generated by the surrounding fans disposed around the fan may also be used as an auxiliary driving force to help the target fan to successfully rotate. In order to increase the wind pressure around the target fan, in some embodiments, a driving voltage of at least one surrounding fan disposed around the target fan is increased, which can drive the airflow to rapidly flow, thereby generating a large auxiliary driving force for the target fan. With cooperation of the auxiliary driving force and the target fan's own driving force, the probability for the target fan to successfully rotate can be greatly increased and it is advantageous for the fan to normally start.

Regarding selection of a fan around the target fan, the fan that is closest to the target fan and has a highest consistency in wind direction may be selected, and its number is not specifically limited herein, which may be determined according to actual requirements.

In some other embodiments, the second driving voltage may be in a value range, for example, smaller than or equal to the maximum rated operating voltage, but greater than or equal to 80%* the maximum rated operating voltage, or smaller than or equal to the maximum rated operating voltage, but greater than or equal to the first value, where the first value is determined according to the following equation: the first value = the first driving voltage+ 50%*(the maximum rated operating voltage- the minimum operating voltage), and the fourth driving voltage may also be in a value range, for example, smaller than or equal to the maximum rated operating voltage, but greater than or equal to the operating voltage before the switching. In this way, the driving voltage obtained when the fan attempts to restart is higher, and the rotor of the fan obtains a large voltage difference change, which may be converted into a larger spinning force, thereby increasing the probability for the fan to successfully rotate. At least one surrounding fan disposed around the target fan may provide a certain wind pressing force.

In some embodiments, the switching the driving voltage of the target fan from the third driving voltage to the second driving voltage to drive the target fan may include, for example, switching the driving voltage of the target fan from the third driving voltage to the second driving voltage, and maintaining output for a first preset time period. In some embodiments of the present disclosure, the first preset time period does not limit the length of the time, and may be, for example, a time period in units of seconds or microseconds. By maintaining the output of the second driving voltage for a certain time period, the driving voltage can be stably outputted, and a conversion of electromagnetic energy to kinetic energy is continued for a certain time period, which also helps to overcome the inertia of the rotor and allows for a successful rotation.

In addition, the switching the driving voltage of the target fan to the third driving voltage, for example, includes: switching the driving voltage of the target fan to the third driving voltage when the target fan is determined to be abnormally started, and maintaining output for a second preset time period.

The second preset time period is less than or equal to the first preset time period.

In some embodiments, the second preset time period may be zero. In an actual operation, considering the time taken for signal switching and for the purpose of reducing the impact of frequent switching on the circuit, the second preset time period may be set to have a certain length of time, but this length of time is much smaller than the first preset time period.

The increasing the driving voltage of the at least one surrounding fan disposed around the target fan to the fourth driving voltage includes, for example, increasing the driving voltage of the at least one surrounding fan to the fourth driving voltage and maintaining output for a third preset time period, where the third preset time period is less than or equal to the first preset time period, for example, the third preset time period ends earlier than or simultaneously with the first preset time period, or the third preset time period starts later than or simultaneously with the first preset time period.

The air flow caused due to the increasing of the rotating speed of the at least one surrounding fan generates a wind pressure, which functions as an auxiliary driving force for the target fan. Therefore, the function time of the at least one surrounding fan may be the same as the duration of the second driving voltage, that is, the third preset time period starts and ends simultaneously with the first preset time period. The function time of the at least one surrounding fan may also be shorter than the duration of the second driving voltage. For example, the third preset time period starts simultaneously with the first preset time period, but ends earlier than the first preset time period.

The above method embodiment, on one hand, increases the target fan's own driving voltage, and on the other hand, provides an auxiliary driving force by means of the wind pressure generated after the driving voltage of the at least one surrounding fan disposed around the target fan is increased, the probability for the target fan to restart can be improved, and it is advantageous for the fan to enter into a normal operating state as soon as possible and exert its heat dissipation effect.

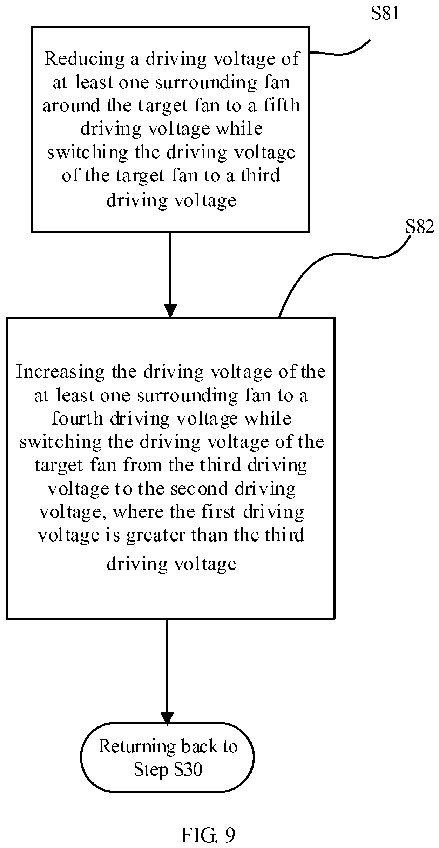

Further, in some other embodiments, on the basis of FIG. 8, as shown in FIG. 9, the method further includes reducing the driving voltage of the at least one surrounding fan disposed around the target fan to a fifth driving voltage while switching the driving voltage of the target fan to the third driving voltage in Step S01.

The switching the driving voltage of the target fan to the third driving voltage, for example, includes: switching the driving voltage of the target fan to the third driving voltage and maintaining output for the second preset time period; and the reducing the driving voltage of the at least one surrounding fan to the fifth driving voltage, for example, includes: reducing the driving voltage of the at least one surrounding fan to the fifth driving voltage and maintaining output for a fourth preset time period, where the fourth preset time period ends earlier than or simultaneously with the second preset time period.

In some embodiments, the third driving voltage is zero, the fifth driving voltage is the minimum operating voltage of the fan, and both the second driving voltage and the fourth driving voltage are the maximum rated operating voltage.

When it is determined that the target fan is started abnormally, the driving voltage of the target fan is first reduced to the minimum, namely zero volt when the fan is restarted, and then increased to the maximum rated operating voltage, so that the target fan obtains a maximum voltage difference. In this way, for the magnetically driven fan, the driving force obtained by the rotor of the fan is the largest, it is advantageous to overcome the inertia of the rotor of the fan and allow for a successful rotation.

At the same time, when the third driving voltage is zero, the fan may be driven and controlled to output a signal corresponding to zero volt voltage, and the system may also be powered off, both of which can achieve the effect that the target fan has no driving voltage.

When the third driving voltage is zero, the second driving voltage is the maximum rated operating voltage, and the second preset time period is zero or is non-zero but significantly smaller than the first preset time period, the target fan can be restarted with the greatest self-driving force in a short time. At the same time, the driving voltage of the at least one surrounding fan is first reduced to the minimum operating voltage, which ensures the basic minimum rotating speed of the fan and the fan is in a rotating state, and then the driving voltage of the at least one surrounding fan is increased to the maximum rated operating voltage of the at least one surrounding fan, and the maximum rated operating voltage may drive the airflow around the target fan to flow at the fastest flow rate. Moreover, since the voltage difference between the maximum rated operating voltage and the minimum operating voltage is large, a significant change in the airflow velocity may be caused, thus generating a maximum auxiliary driving force to the target fan. With cooperation of the auxiliary driving force and the target fan's own driving force, it is easier to overcome the inertia of the rotor and greatly increase the probability for the fan to successfully rotate.

Generally, multiple fans are disposed in a device, and these fans have the same model. Therefore, they are consistent in terms of parameters such as the minimum operating voltage, the maximum rated operating voltage, and the starting voltage.

In some embodiments, the fourth preset time period may be shorter than the third preset time period. That is, the duration the at least one surrounding fan is driven with a low voltage is shorter, but the duration the at least one surrounding fan is driven with a high voltage is longer. Therefore, the heat dissipation effect of the fan is less affected.

In some embodiments, the second preset time period and the fourth preset time period may take shorter durations, which are significantly shorter than the first preset time period and the third preset time period, respectively. Alternatively, when the process of switching from the first driving voltage to the third driving voltage and then switching to the second driving voltage is completed instantaneously, it can also be considered that the second preset time period is substantially zero. Also, when the process of reducing the driving voltage of the at least one fan around the target fan from the current operating voltage to the fifth driving voltage and then switching to the fourth driving voltage is completed instantaneously, it can also be considered that the fourth preset time period is substantially zero.

Generally, in order to reduce the impact of frequent switching on the circuit, the second preset time period and the fourth preset time period may be appropriately set as a time period. This also ensures that the duration the fan is driven with a high voltage is relatively long, and the total length of time may be compressed, allowing the fan to complete the restarting process faster.

According to the above-mentioned technical solutions provided in some other embodiments of the present disclosure, on one hand, during the starting process of the heat dissipation fan, if it is determined that the rotating speed of the fan is zero, then the target fan is restarted, a self-recovery starting process can be performed for the abnormal fan, the continuity of the operation of the fan is improved, and the reliability of the operation of the fan is also improved. The technical solution of the present disclosure provides a self-recovery mechanism of the fan, such that the abnormal fan is switched to a high driving voltage to perform automatic restarting, and is brought into a normal operating state after a successful restarting, which continues to run and perform the heat dissipation, moreover, normal operations of other components of the device will not be affected, and maintenance costs of the device are reduced.

On the other hand, during the restarting process of the target fan, not only by increasing the target fan's own driving voltage, but also utilizing its own driving force, and by means of the wind pressure auxiliary driving force generated after the driving voltage of the at least one surrounding fan disposed around the target fan is increased, the probability for the target fan to restart may be greatly increased, such that the fan is quickly brought into the normal operating state to exert its heat dissipation effect, meanwhile less influence is caused for the surrounding fans and the continuity of the operation of the device is ensured.

The above implementation processes are all completed within the laser projection device without participations from maintenance personnel and users. An intelligent device self-recovery mechanism is provided, which has a high value of product application, and can improve the competitiveness of the product.

Based on the embodiments as shown in FIG. 8 and FIG. 9, reference may also be made to one of the embodiments as shown in FIG. 5-FIG. 7 for the technical solutions of some other embodiments of the present disclosure.

In some embodiments, during the restarting process of the fan, after Step S72 and before returning back to Step S30, the method further includes: determining whether a cycle number of switching to the second driving voltage is greater than a first preset number threshold; if it is greater than the first preset number threshold, stopping the target fan from restarting, and issuing a warning; if it is less than the first preset number threshold, then returning back to Step S30, where the first preset number threshold is an integer greater than or equal to 1.

In some embodiments, the first preset number threshold may be set to 1 or 2, or 3, or 5, which may be adjusted according to software design requirements. Therefore, after a limited number of attempts to restart, the action of restarting the fan is stopped if the restarting process is still unsuccessful, and it is considered that the fan is in abnormality and a warning is issued.

In other embodiments, during the restarting process of the fan, after Step S72 and before returning back to Step S30, the method further includes:
detecting whether a temperature at a temperature control point is greater than a first preset temperature threshold,
if it is greater than the first preset temperature threshold, stopping the fan from restarting, and issuing a warning;
if it is not greater than the first preset temperature threshold, returning back to Step S30.

In some other embodiments, during the restarting process of the fan, after Step S72 and before returning back to Step S30, the method further includes: determining whether a cycle number of switching to the second driving voltage is greater than a second preset number threshold or detecting whether a temperature at the temperature control point is greater than a second preset temperature threshold,
if the cycle number is greater than the second preset number threshold or the temperature at the temperature control point is greater than the second preset temperature threshold, stopping the fan from restarting, and issuing a warning;
if the cycle number is not greater than the second preset number threshold and the temperature at the temperature control point is not greater than the second preset temperature threshold, returning back to Step S30; where the second preset number threshold is an integer greater than or equal to 1.

For software implementations, these techniques may be implemented with modules (e.g., programs, functions, or the like) that implement the functions described herein. A software code may be stored in a memory unit and executed by a processor. The memory unit can be implemented inside the processor or outside the processor.

The present disclosure is described with reference to flowcharts and/or block diagrams of methods, devices (systems), and computer program products according to some embodiments of the present disclosure. It should be understood that each flow and/or block in the flowcharts and/or block diagrams, and a combination of the flow and/or block in the flowcharts and/or block diagrams may be implemented by computer program instructions. The computer program instructions may be provided to a processor of a general purpose computer, a special purpose computer, an embedded processor, or other programmable data processing device to produce a machine for enabling the instructions executed by the processor of the computer or other programmable data processing devices to produce a device for implementing a function specified in one or more flows of the flowchart and/or one or more blocks of the block diagram.

These computer program instructions may also be stored in a computer readable memory capable of directing the computer or other programmable data processing devices to operate in a specific manner, so that instructions stored in the computer readable memory produce a manufacture including an instruction device for implementing the functions specified in one or more flows of the flowchart and/or one or more blocks of the block diagram.

These computer program instructions can also be loaded onto the computer or other programmable data processing devices, such that a series of operational steps are performed on the computer or other programmable devices to generate computer-implemented processes, so that the instructions executed on a computer or other programmable devices provide steps for implementing the functions specified in one or more flows of the flowchart and/or one or more blocks of the block diagram.

Although some embodiments of the present disclosure have been described, those skilled in the art can make additional changes and modifications to these embodiments once they learn the basic inventive concept. Therefore, the appended claims are intended to be interpreted as including these embodiments and all changes and modifications that fall into the scope of the disclosure.

Thus, if these modifications and variations of the present disclosure fall into the scope of the claims of the present disclosure and their equivalents, the present disclosure is also intended to include these modifications and variations.

## Claims

1. A method for starting a heat dissipation fan, comprising:
driving (S10) a fan with a first driving voltage and detecting (S30) a rotating speed of the fan; and
in response to the rotating speed of the fan being lower than a preset rotating speed threshold, switching (SOI) a driving voltage of the fan to a third driving voltage first, and then switching (S02) the driving voltage of the fan from the third driving voltage to a second driving voltage, wherein the second driving voltage is greater than the first driving voltage, the third driving voltage is smaller than the first driving voltage, and the preset rotating speed threshold is configured to indicate that the fan is abnormally started.

2. The method for starting the heat dissipation fan of claim 1, wherein the third driving voltage is 0V.

3. The method for starting the heat dissipation fan of claim 1, wherein the switching (SOI) the driving voltage of the fan to the third driving voltage first, and then switching (S02) the driving voltage of the fan from the third driving voltage to the second driving voltage comprises at least one of the following:
switching the driving voltage of the fan to the third driving voltage first, then switching the driving voltage of the fan from the third driving voltage to the second driving voltage, and maintaining output of the second driving voltage within a first preset time period; and
switching the driving voltage of the fan to the third driving voltage first, maintaining output of the third driving voltage within a second preset time period, and then switching the driving voltage of the fan from the third driving voltage to the second driving voltage.

4. The method for starting the heat dissipation fan of claim 1, wherein at least one surrounding fan is disposed around the fan; and
the method further comprises increasing (S72, S82) a driving voltage of the at least one surrounding fan to a fourth driving voltage while switching the driving voltage of the fan from the third driving voltage to the second driving voltage.

5. The method for starting the heat dissipation fan of claim 4, further comprising: reducing (S81) the driving voltage of the at least one surrounding fan to a fifth driving voltage while switching the driving voltage of the fan to the third driving voltage.

6. The method for starting the heat dissipation fan of claim 5, wherein the fourth driving voltage and the fifth driving voltage satisfy at least one of the following conditions:
the fifth driving voltage is a minimum operating voltage of the at least one surrounding fan; and
the fourth driving voltage is a maximum rated operating voltage of the at least one surrounding fan.

7. The method for starting the heat-dissipating fan of claim 5, wherein the reducing (S81) the driving voltage of the at least one surrounding fan to the fifth driving voltage and increasing (S82) the driving voltage of the at least one surrounding fan to the fourth driving voltage comprises at least one of the following:
reducing the driving voltage of the at least one surrounding fan to the fifth driving voltage first, then increasing the driving voltage of the at least one surrounding fan to the fourth driving voltage, and maintaining output of the fourth driving voltage within a third preset time period, wherein the fourth preset time period ends earlier than or simultaneously with the second preset time period;
reducing the driving voltage of the at least one surrounding fan to the fifth driving voltage first, maintaining output of the fifth driving voltage within a fourth preset time period, and then increasing the driving voltage of the at least one surrounding fan to the fourth driving voltage, wherein the third preset time period starts later than or simultaneously with the first preset time period.

8. The method for starting the heat dissipation fan of claim 1, upon detection of the rotating speed of the fan, further comprising:
in response to a cycle number of switching to the second driving voltage being greater than a first preset number threshold, stopping the fan from starting, and issuing an warning;
in response to the cycle number of switching to the second driving voltage being not greater than the first preset number threshold, when the rotating speed of the fan is lower than the preset rotating speed threshold, switching the driving voltage of the fan to the second driving voltage; wherein the first preset number threshold is an integer greater than or equal to 1.

9. The method for starting the heat dissipation fan according to claim 1, wherein in response to the rotating speed of the fan being lower than the preset rotating speed threshold, the switching (SOI) the driving voltage of the fan to the third driving voltage first, and then switching (S02) the driving voltage of the fan from the third driving voltage to the second driving voltage comprises:
in response to the rotating speed of the fan being lower than the preset rotating speed threshold, when a time of duration for the rotating speed of the fan being lower than the preset rotating speed threshold exceeds a preset time threshold, switching the driving voltage of the fan to the third driving voltage first, and then switching the driving voltage of the fan from the third driving voltage to the second driving voltage.

10. A laser projection device, comprising:
a fan;
a non-volatile memory for storing instructions;
a processor coupled to the non-volatile memory, wherein the processor is configured to execute the instructions stored in the non-volatile memory, and the processor is configured to:
drive the fan with a first driving voltage and detect a rotating speed of the fan;
in response to the rotating speed of the fan being lower than a preset rotating speed threshold, switch a driving voltage of the fan to a third driving voltage first, then switch the driving voltage of the fan from the third driving voltage to a second driving voltage, wherein the second driving voltage is greater than the first driving voltage, the third driving voltage is smaller than the first driving voltage, and the preset rotating speed threshold is configured to indicate that the fan is abnormally started.

11. The laser projection device of claim 10, wherein the third driving voltage is 0V.

12. The laser projection device of claim 10, wherein at least one surrounding fan is disposed around the fan; the processor is configured to:
increase a driving voltage of the at least one surrounding fan to a fourth driving voltage while switching the driving voltage of the fan from the third driving voltage to the second driving voltage.

13. The laser projection device of claim 12, wherein the processor is configured to: reduce the driving voltage of the at least one surrounding fan to a fifth driving voltage while switching the driving voltage of the fan to the third driving voltage.

## Patentansprüche

1. Verfahren zum Starten eines Wärmeabfuhrgebläses, das Folgendes umfasst:
Antreiben (S10) eines Gebläses mit einer ersten Antriebsspannung und Erfassen (S30) einer Drehzahl des Gebläses; und
als Reaktion darauf, dass die Drehzahl des Gebläses kleiner ist als ein voreingestellter Drehzahlschwellenwert, Umschalten (S01) einer Antriebsspannung des Gebläses zunächst auf eine dritte Antriebsspannung, und dann Umschalten (S02) der Antriebsspannung des Gebläses von der dritten Antriebsspannung auf eine zweite Antriebsspannung , wobei die zweite Antriebsspannung größer ist als die erste Antriebsspannung, wobei die dritte Antriebsspannung kleiner ist als die erste Antriebsspannung, und der voreingestellte Drehzahlschwellenwert konfiguriert ist, um anzugeben, dass das Gebläse anormal gestartet wird.

2. Verfahren zum Starten des Wärmeabfuhrgebläses nach Anspruch 1, wobei die dritte Antriebsspannung 0 V beträgt.

3. Verfahren zum Starten des Wärmeabfuhrgebläses nach Anspruch 1, wobei das Umschalten (S01) der Antriebsspannung des Gebläses zunächst auf die dritte Antriebsspannung, und dann das Umschalten (S02) der Antriebsspannung des Gebläses von der dritten Antriebsspannung auf die zweite Antriebsspannung mindestens eines der Folgenden umfasst:
zunächst Umschalten der Antriebsspannung des Gebläses auf die dritte Antriebsspannung, dann Umschalten der Antriebsspannung des Gebläses von der dritten Antriebsspannung auf die zweite Antriebsspannung, und Aufrechterhalten der Ausgabe der zweiten Antriebsspannung innerhalb einer ersten voreingestellten Zeitspanne; und
zunächst Umschalten der Antriebsspannung des Gebläses auf die dritte Antriebsspannung, Aufrechterhalten der Ausgabe der dritten Antriebsspannung innerhalb einer zweiten voreingestellten Zeitspanne, und dann Umschalten der Antriebsspannung des Gebläses von der dritten Antriebsspannung auf die zweite Antriebsspannung.

4. Verfahren zum Starten des Wärmeabfuhrgebläses nach Anspruch 1, wobei mindestens ein umgebendes Gebläse um das Gebläse angeordnet ist; und
das Verfahren ferner das Steigern (S72, S82) einer Antriebsspannung des mindestens einen umgebenden Gebläses auf eine vierte Antriebsspannung umfasst, während die Antriebsspannung des Gebläses von der dritten Antriebsspannung auf die zweite Antriebsspannung umgeschaltet wird.

5. Verfahren zum Starten des Wärmeabfuhrgebläses nach Anspruch 4, das ferner Folgendes umfasst: Reduzieren (S81) der Antriebsspannung des mindestens einen umgebenden Gebläses auf eine fünfte Antriebsspannung, während die Antriebsspannung des Gebläses auf die dritte Antriebsspannung umgeschaltet wird.

6. Verfahren zum Starten des Wärmeabfuhrgebläses nach Anspruch 5, wobei die vierte Antriebsspannung und die fünfte Antriebsspannung mindestens eine der folgenden Bedingungen erfüllen:
die fünfte Antriebsspannung ist eine Mindestbetriebsspannung des mindestens einen umgebenden Gebläses; und
die vierte Antriebsspannung ist eine maximale Nennbetriebsspannung des mindestens einen umgebenden Gebläses.

7. Verfahren zum Starten des Wärmeabfuhrgebläses nach Anspruch 5, wobei das Reduzieren (S81) der Antriebsspannung des mindestens einen umgebenden Gebläses auf die fünfte Antriebsspannung und das Steigern (S82) der Antriebsspannung des mindestens einen umgebenden Gebläses auf die vierte Antriebsspannung mindestens eines der Folgenden umfasst:
zunächst Reduzieren der Antriebsspannung des mindestens einen umgebenden Gebläses auf die fünfte Antriebsspannung, dann Steigern der Antriebsspannung des mindestens einen umgebenden Gebläses auf die vierte Antriebsspannung und Aufrechterhalten der Ausgabe der vierten Antriebsspannung innerhalb einer dritten voreingestellten Zeitspanne, wobei die vierte voreingestellte Zeitspanne früher endet als oder gleichzeitig endet wie die zweite voreingestellte Zeitspanne;
Reduzieren der Antriebsspannung des mindestens einen umgebenden Gebläses auf die fünfte Antriebsspannung, dann Aufrechterhalten der Ausgabe der fünften Antriebsspannung innerhalb einer vierten voreingestellten Zeitspanne, und dann Steigern der Antriebsspannung des mindestens einen umgebenden Gebläses auf die vierte Antriebsspannung, wobei die dritte voreingestellte Zeitspanne später startet als oder gleichzeitig startet wie die erste voreingestellte Zeitspanne.

8. Verfahren zum Starten des Wärmeabfuhrgebläses nach Anspruch 1 bei Erfassen der Drehzahl des Gebläses, das Folgendes umfasst:
als Reaktion darauf, dass eine Zyklenanzahl des Umschaltens auf die zweite Antriebsspannung größer ist als eine erste voreingestellte Schwellenanzahl, Verhindern des Startens des Gebläses und Ausgeben einer Warnung;
als Reaktion darauf, dass die Zyklenanzahl des Umschaltens auf die zweite Antriebsspannung nicht größer ist als die erste voreingestellte Schwellenanzahl, wenn die Drehzahl des Gebläses kleiner ist als der voreingestellte Drehzahlschwellenwert, Umschalten der Antriebsspannung des Gebläses auf die zweite Antriebsspannung; wobei die erste voreingestellte Schwellenanzahl eine Ganzzahl größer oder gleich 1 ist.

9. Verfahren zum Starten des Wärmeabfuhrgebläses nach Anspruch 1, wobei als Reaktion darauf, dass die Drehzahl des Gebläses kleiner ist als der voreingestellte Drehzahlschwellenwert, das Umschalten (S01) der Antriebsspannung des Gebläses zunächst auf die dritte Antriebsspannung und dann das Umschalten (S02) der Antriebsspannung des Gebläses von der dritten Antriebsspannung auf die zweite Antriebsspannung Folgendes umfasst:
als Reaktion darauf, dass die Drehzahl des Gebläses kleiner ist als der voreingestellte Drehzahlschwellenwert, wenn eine Dauer dafür, dass die Drehzahl des Gebläses kleiner ist als der voreingestellte Drehzahlschwellenwert, einen voreingestellten Zeitschwellenwert überschreitet, Umschalten der Antriebsspannung des Gebläses zunächst auf die dritte Antriebsspannung, und dann Umschalten der Antriebsspannung des Gebläses von der dritten Antriebsspannung auf die zweite Antriebsspannung.

10. Laserprojektionsgerät, das Folgendes umfasst:
ein Gebläse; einen nichtflüchtigen Speicher zum Speichern von Anweisungen;
einen Prozessor, der mit dem nichtflüchtigen Speicher gekoppelt ist, wobei der Prozessor konfiguriert ist, um die Anweisungen, die in dem nichtflüchtigen Speicher gespeichert sind, auszuführen, und der Prozessor konfiguriert ist, um:
das Gebläse mit einer ersten Antriebsspannung anzutreiben und eine Drehzahl des Gebläses zu erfassen;
als Reaktion darauf, dass die Drehzahl des Gebläses kleiner ist als ein voreingestellter Drehzahlschwellenwert, zunächst Umschalten einer Antriebsspannung des Gebläses auf eine dritte Antriebsspannung, dann Umschalten der Antriebsspannung des Gebläses von der dritten Antriebsspannung auf eine zweite Antriebsspannung, wobei die zweite Antriebsspannung größer ist als die erste Antriebsspannung, wobei die dritte Antriebsspannung kleiner ist als die erste Antriebsspannung, und der voreingestellte Drehzahlschwellenwert konfiguriert ist, um anzugeben, dass das Gebläse anormal gestartet wird.

11. Laserprojektionsgerät nach Anspruch 10, wobei die dritte Antriebsspannung 0 V beträgt.

12. Laserprojektionsgerät nach Anspruch 10, wobei mindestens ein umgebendes Gebläse um das Gebläse angeordnet ist; wobei der Prozessor konfiguriert ist, um:
eine Antriebsspannung des mindestens einen umgebenden Gebläses auf eine vierte Antriebsspannung zu steigern, während die Antriebsspannung des Gebläses von der dritten Antriebsspannung auf die zweite Antriebsspannung umgeschaltet wird.

13. Laserprojektionsgerät nach Anspruch 12, wobei der Prozessor konfiguriert ist, um: die Antriebsspannung des mindestens einen umgebenden Gebläses auf eine fünfte Antriebsspannung zu reduzieren, während die Antriebsspannung des Gebläses auf die dritte Antriebsspannung umgeschaltet wird.

## Revendications

1. Procédé pour démarrer un ventilateur de dissipation de chaleur, comprenant :
l'excitation (S10) d'un ventilateur avec une première tension d'excitation et la détection (S30) d'une vitesse de rotation du ventilateur ; et
en réponse au fait que la vitesse de rotation du ventilateur est inférieure à un seuil prédéfini de vitesse de rotation, la commutation (S01) d'une tension d'excitation du ventilateur à une troisième tension d'excitation en premier, et puis la commutation (S02) de la tension d'excitation du ventilateur de la troisième tension d'excitation à une deuxième tension d'excitation, dans lequel la deuxième tension d'excitation est supérieure à la première tension d'excitation, la troisième tension d'excitation est inférieure à la première tension d'excitation, et le seuil prédéfini de vitesse de rotation est configuré pour indiquer que le ventilateur est démarré de façon anormale.

2. Procédé pour démarrer le ventilateur de dissipation de chaleur selon la revendication 1, dans lequel la troisième tension d'excitation est de 0 V.

3. Procédé pour démarrer le ventilateur de dissipation de chaleur selon la revendication 1, dans lequel la commutation (S01) de la tension d'excitation du ventilateur à la troisième tension d'excitation en premier, et puis la commutation (S02) de la tension d'excitation du ventilateur de la troisième tension d'excitation à la deuxième tension d'excitation comprend au moins une des suivantes :
la commutation de la tension d'excitation du ventilateur à la troisième tension d'excitation en premier, puis la commutation la tension d'excitation du ventilateur de la troisième tension d'excitation à la deuxième tension d'excitation, et le maintien de la sortie de la deuxième tension d'excitation au sein d'une première période prédéfinie ; et
la commutation la tension d'excitation du ventilateur à la troisième tension d'excitation en premier, le maintien de la sortie de la troisième tension d'excitation au sein d'une deuxième période prédéfinie, et puis la commutation de la tension d'excitation du ventilateur de la troisième tension d'excitation à la deuxième tension d'excitation.

4. Procédé pour démarrer le ventilateur de dissipation de chaleur selon la revendication 1, dans lequel au moins un ventilateur entourant est disposé autour du ventilateur ; et
le procédé comprend en outre l'augmentation (S72, S82) d'une tension d'excitation de l'au moins un ventilateur entourant jusqu'à une quatrième tension d'excitation simultanément à la commutation de la tension d'excitation du ventilateur de la troisième tension d'excitation à la deuxième tension d'excitation.

5. Procédé pour démarrer le ventilateur de dissipation de chaleur selon la revendication 4, comprenant en outre : la réduction (S81) de la tension d'excitation de l'au moins un ventilateur entourant jusqu'à une cinquième tension d'excitation simultanément à la commutation de la tension d'excitation du ventilateur à la troisième tension d'excitation.

6. Procédé pour démarrer le ventilateur de dissipation de chaleur selon la revendication 5, dans lequel la quatrième tension d'excitation et la cinquième tension d'excitation satisfont à au moins une des suivantes conditions :
la cinquième tension d'excitation est une tension de fonctionnement minimum de l'au moins un ventilateur entourant ; et
la quatrième tension d'excitation est une tension de fonctionnement nominale maximum de l'au moins un ventilateur entourant.

7. Procédé pour démarrer le ventilateur de dissipation de chaleur selon la revendication 5, dans lequel la réduction (S81) de la tension d'excitation de l'au moins un ventilateur entourant jusqu'à la cinquième tension d'excitation et l'augmentation (S82) de la tension d'excitation de l'au moins un ventilateur entourant jusqu'à la quatrième tension d'excitation comprend au moins une des suivantes :
la réduction de la tension d'excitation de l'au moins un ventilateur entourant jusqu'à la cinquième tension d'excitation en premier, puis l'augmentation de la tension d'excitation de l'au moins un ventilateur entourant jusqu'à la quatrième tension d'excitation, et le maintien de la sortie de la quatrième tension d'excitation au sein d'une troisième période prédéfinie, dans lequel la quatrième période prédéfinie se termine avant ou simultanément à la deuxième période prédéfinie ;
la réduction de la tension d'excitation de l'au moins un ventilateur entourant jusqu'à la cinquième tension d'excitation en premier, le maintien de la sortie de la cinquième tension d'excitation au sein d'une quatrième période prédéfinie, et puis l'augmentation de la tension d'excitation de l'au moins un ventilateur entourant jusqu'à la quatrième tension d'excitation, dans lequel la troisième période prédéfinie commence après ou simultanément à la première période prédéfinie.

8. Procédé pour démarrer le ventilateur de dissipation de chaleur selon la revendication 1, lors de la détection de la vitesse de rotation du ventilateur, comprenant en outre :
en réponse au fait qu'un nombre de cycles de la commutation à la deuxième tension d'excitation est supérieur à un premier seuil de nombre prédéfini, la prévention du démarrage du ventilateur, et l'émission d'un avertissement ;
en réponse au fait que le nombre de cycles de la commutation à la deuxième tension d'excitation n'est pas supérieur au premier seuil de nombre prédéfini, lorsque la vitesse de rotation du ventilateur est inférieure au seuil prédéfini de vitesse de rotation, la commutation de la tension d'excitation du ventilateur à la deuxième tension d'excitation ; dans lequel le premier seuil de nombre prédéfini est un nombre entier relatif supérieur ou égal à 1.

9. Procédé pour démarrer le ventilateur de dissipation de chaleur selon la revendication 1, dans lequel, en réponse au fait que la vitesse de rotation du ventilateur est inférieure au seuil prédéfini de vitesse de rotation, la commutation (S01) de la tension d'excitation du ventilateur à la troisième tension d'excitation en premier, et puis la commutation (S02) de la tension d'excitation du ventilateur de la troisième tension d'excitation à la deuxième tension d'excitation comprend :
en réponse au fait que la vitesse de rotation du ventilateur est inférieure au seuil prédéfini de vitesse de rotation, lorsqu'un temps de durée pour la vitesse de rotation du ventilateur inférieure au seuil prédéfini de vitesse de rotation dépasse un seuil de temps prédéfini, la commutation de la tension d'excitation du ventilateur à la troisième tension d'excitation en premier, et puis la commutation de la tension d'excitation du ventilateur de la troisième tension d'excitation à la deuxième tension d'excitation.

10. Dispositif de projection laser, comprenant :
un ventilateur ;
une mémoire non volatile pour stocker des instructions ;
un processeur couplé à la mémoire non volatile, dans lequel le processeur est configuré pour exécuter les instructions stockées dans la mémoire non volatile, et le processeur est configuré pour :
exciter le ventilateur avec une première tension d'excitation et détecter une vitesse de rotation du ventilateur ;
en réponse au fait que la vitesse de rotation du ventilateur est inférieure à un seuil prédéfini de vitesse de rotation, commuter une tension d'excitation du ventilateur à une troisième tension d'excitation en premier, puis commuter la tension d'excitation du ventilateur de la troisième tension d'excitation à une deuxième tension d'excitation, dans lequel la deuxième tension d'excitation est supérieure à la première tension d'excitation, la troisième tension d'excitation est inférieure à la première tension d'excitation, et le seuil prédéfini de vitesse de rotation est configuré pour indiquer que le ventilateur est démarré de façon anormale.

11. Dispositif de projection laser selon la revendication 10, dans lequel la troisième tension d'excitation est de 0 V.

12. Dispositif de projection laser selon la revendication 10, dans lequel au moins un ventilateur entourant est disposé autour du ventilateur; le processeur est configuré pour :
augmenter une tension d'excitation de l'au moins un ventilateur entourant jusqu'à une quatrième tension d'excitation tout en commutant la tension d'excitation du ventilateur de la troisième tension d'excitation à la deuxième tension d'excitation.

13. Dispositif de projection laser selon la revendication 12, dans lequel le processeur est configuré pour : réduire la tension d'excitation de l'au moins un ventilateur entourant jusqu'à une cinquième tension d'excitation tout en commutant la tension d'excitation du ventilateur à la troisième tension d'excitation.
